Europäisches Patentamt

European Patent Office

Office européen des brevets

(19)

(11) EP 0 865 125 A1

(12) **EUROPEAN PATENT APPLICATION**

(43) Date of publication:
16.09.1998 Bulletin 1998/38

(51) Int Cl.⁶: $H01S\ 3/19$

(21) Application number: 98301396.2

(22) Date of filing: 25.02.1998

(84) Designated Contracting States:
AT BE CH DE DK ES FI FR GB GR IE IT LI LU MC NL PT SE
Designated Extension States:
AL LT LV MK RO SI

(30) Priority: 07.03.1997 JP 53056/97

(71) Applicant: Oki Electric Industry Co., Ltd.
Tokyo (JP)

(72) Inventors:
• Munakata, Tsutomu
7-12, Toranomon 1-chome, Minato-ku Tokyo (JP)
• Kashima, Yasumasa
7-12, Toranomon 1-chome, Minato-ku Tokyo (JP)

(74) Representative: Read, Matthew Charles et al
Venner Shipley & Co.
20 Little Britain
London EC1A 7DH (GB)

(54) **Semiconductor laser with multiple quantum well structure**

(57) A semiconductor laser having a multiple quantum well structure includes alternating well and barrier layers, with the barrier layers being InGaAlAs. The well layers may be InGaAs or InGaAsP. These materials increase the internal quantum efficiency of the laser, while decreasing electron over-flow from the quantum well.

Fig. 2

## Description

The present invention generally relates to a semiconductor laser, and more particularly, the present invention relates to a semiconductor laser having a multiple quantum well structure.

A multiple quantum well semiconductor laser and a multiple quantum well light emitting diode are known types of semiconductor light emitting devices.

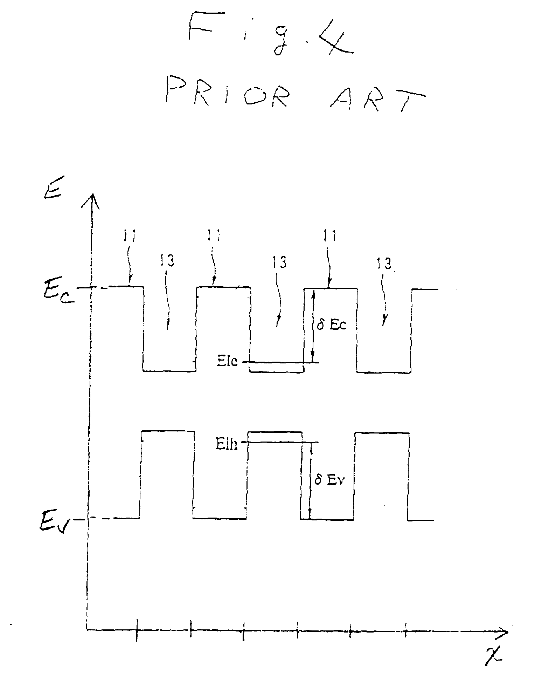

Figure 4 shows a band diagram for a conventional semiconductor laser having a multiple quantum well structure.

In Figure 4, x represents the depth direction of the multiple quantum well and E denotes an energy level. The multiple quantum well is comprised of alternating barrier layers 11 and well layers 13. Conventionally, the barrier layers 11 are formed of InGaAsP and the well layers 13 are formed of InGaAs. Ec and Ev denote the conduction band energy level and the valence band energy level, respectively, of the barrier layers 11.

Semiconductor laser emission is caused by recombination of the electrons at the first quantum level Ele of the conduction band of the well layer and the holes at the first quantum level Elh of the valence band of the well layer. In this regard, $\delta Ec$ is defined as the energy between the first quantization level of electron to the conduction band edge of the barrier layer. Similarly $\delta Ev$ denotes the energy between the first quantization level of heavy hole to the valence band edge of the barrier layer.

$\delta Ev$ and $\delta Ec$ can be calculated using model solid theory (see Model Solid Theory: Chris G. Van de Walle, Physical Review B Vol. 39, pp 1871 (1989), which is incorporated herein by reference). As mentioned above, the conventional structure employs InGaAsP as the barrier layers 11, and InGaAs as the well layers 13. In such a structure, $\delta Ev = 132.9$ (meV) and $\delta Ec = 85.9$ (meV), in the case where the InGaAsP has a compressive strain of 0%, a bandgap wavelength ($\lambda$) of 1.4µm, and a thickness of 10nm, and the InGaAs has a compressive strain of 0.6%, a bandgap wavelength ($\lambda$) of 1.92µm, and a thickness of 6nm.

Since the mass of a hole is greater than that of an electron and therefore is more difficult to move, and since $\delta Ev$ is 89.3 (meV) compared to 131.8 (meV) for $\delta Ec$, there is a decreased probability of electron and hole recombination, as well as an increased probability of electron over-flow from the quantum well. These factors negatively affect the internal quantum efficiency and power of the semiconductor laser.

An object of the present invention is to provide a semiconductor laser having a multiple quantum well structure that can achieve high power.

According to one aspect of the present invention, for achieving the above object, there is provided a semiconductor laser comprising a multiple quantum well structure having a well layer and a barrier layer, wherein the barrier layer comprises InGaAlAs.

According to another aspect of the present invention, for achieving the above object, there is provided a semiconductor laser, wherein the barrier layer comprises InGaAlAs and the well layer comprises InGaAs.

According to another aspect of the present invention, for achieving the above object, there is provided a semiconductor laser, wherein the barrier layer comprises InGaAlAs and the well layer comprises InGaAsP.

According to another aspect of the present invention, for achieving the above object, there is provided a semiconductor laser, wherein the multiple quantum well structure includes a plurality of alternating well and barrier layers sandwiched between separated confinement heterostructure layers and a clad layer formed on one of the separated confinement heterostructure layers, wherein the barrier layer comprises InGaAlAs.

While the specification concludes with claims particularly pointing out and distinctly claiming the subject matter that is regarded as the invention, the invention, along with the objects, features and advantages thereof, will be better understood from the following description taken in connection with the accompanying drawings, in which:

Figure 1 is a perspective view showing a semiconductor laser having a multiple quantum well structure according to the present invention;

Figure 2 shows a band diagram for a semiconductor laser having a multiple quantum well structure according to a first preferred embodiment of a present invention;

Figure 3 shows a band diagram for a semiconductor laser having a multiple quantum well structure according to a second preferred embodiment of a present invention; and

Figure 4 shows a band diagram for a conventional semiconductor laser having a multiple quantum well structure.

A first preferred semiconductor laser having a multiple quantum well structure according to the present invention will hereinafter be described in detail with reference to the accompanying drawings.

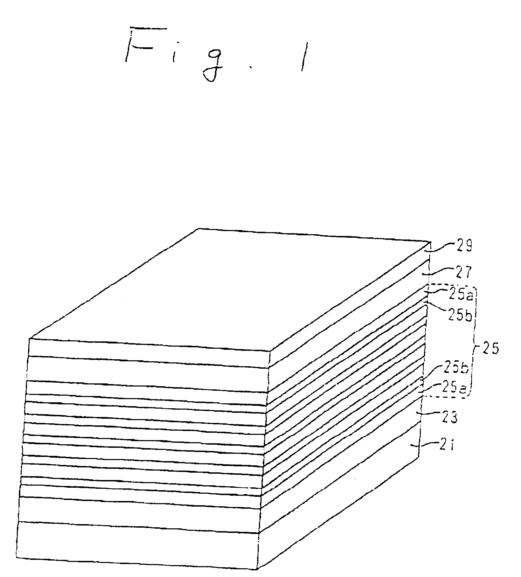

Figure 1 is a perspective view showing a semiconductor laser having a multiple quantum well structure according to a first preferred embodiment of a present invention.

The semiconductor laser of the first preferred embodiment includes a first conductive type InP structure 21, a first SCH (Separated Confinement Heterostructure) layer 23 formed on the InP substrate 21, a multiple quantum well structure 25 formed on the first SCH layer 23, a second SCH layer 27 formed on the multiple quantum well structure 25 and an InP clad layer 29.

Here, the first SCH layer 23 is preferably an InGaAlAs layer (compressive strain: 0%, bandgap wavelength ($\lambda$): 1.2µm, thickness: 25nm).

The multiple quantum well structure 25 preferably includes five quantum wells, each of which is made up of a well layer 25b sandwiched between barrier layers 25a. The barrier layer 25a is preferably an InGaAlAs layer (compressive strain : 0%, bandgap wavelength ($\lambda$): 1.4$\mu$m, thickness: 10nm), while the well layer 25b is preferably an InGaAs layer (compressive strain : 0.6%, bandgap wavelength ($\lambda$): 1.92$\mu$m, thickness: 6nm).

The structure of the second SCH layer 27 is preferably the same as that of the first SCH layer 23.

All of the first and second SCH layers 23 and 27, the barrier layers 25a, the well layers 25b and the InP clad layer 29 can be formed using known MOCVD or MBE fabrication methods.

Next $\delta$Ev and $\delta$Ec of the multiple quantum well laser of the present invention will be compared with that of the conventional multiple quantum well laser. As mentioned above, $\delta$Ec is defined as the energy between the first quantization level of electron to the conduction band edge of the barrier layer. Similarly, $\delta$Ev denotes the energy between the first quantization level of heavy hole to the valence band edge of the barrier layer. Again, $\delta$Ev and $\delta$Ec can be calculated using model solid theory.

Except for the material used to form the barrier layer, the structure of the conventional semiconductor laser having a multiple quantum well structure is essentially the same as that of the first preferred embodiment of the present invention.

That is, the barrier layer of the present invention is an InGaAlAs layer (compressive strain: 0%, bandgap wavelength ($\lambda$): 1.4$\mu$m), whereas the barrier layer of the conventional semiconductor laser is an InGaAsP layer (compressive strain: 0%, bandgap wavelength ($\lambda$): 1.4$\mu$m). In both cases, InGaAs is used as the well layer (compressive strain: 0.6%, bandgap wavelength ($\lambda$): 1.92$\mu$m).

The result of calculating of $\delta$Ev and $\delta$Ec is as follows:

InGaAlAs layer as the barrier layer : $\delta$Ev = 89.3 (meV), $\delta$Ec = 131.8 (meV)
InGaAsP layer as the barrier layer : $\delta$Ev - 132.9 (meV), $\delta$Ec = 85.9 (meV)

As shown above, by adopting InGaAlAs as the barrier layer, $\delta$Ev decreases and $\delta$Ec increases in the structure of the present invention.

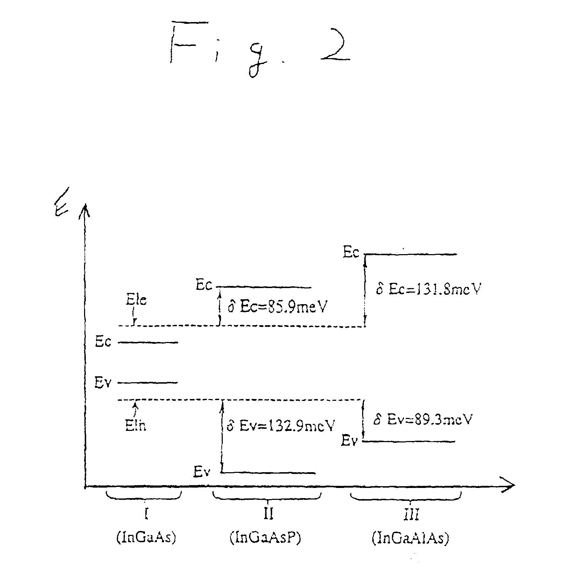

Turning now to Figure 2, regions I and II show band-diagrams of InGaAs as the well layer and InGaAsP layer as the barrier layer according to the conventional semiconductor laser, and regions I and III show band-diagrams of InGaAs as the well layer and InGaAlAs as the barrier layer according to the first preferred embodiment of the present invention.

Emission of the semiconductor laser is caused in the recombination between electrons of a first quantum level Ele in the conduction band of the well layer and heavy hole of a first quantum level Elh of the valence band of a well layer. However, a hole is more difficult to move since its mass is heavier than that of an electron. The first preferred embodiment decreases $\delta$Ev. Therefore the probability of the recombination between electrons and holes increases, and as a result, the internal quantum efficiency of the semiconductor laser increases. Also, the first preferred embodiment increases $\delta$Ec. Therefore, the probability of electron over-flow from the quantum well decreases. Accordingly, the first preferred embodiment can achieve a semiconductor laser of high power.

A second preferred embodiment of the semiconductor laser having a multiple quantum well structure according to the present invention will hereinafter be described in detail.

The feature of the semiconductor laser of the second preferred embodiment is to adopt InGaAsP as the well layer instead of InGaAs, and to use InGaAlAs as the barrier layer as in the first embodiment.

Next, $\delta$Ev and $\delta$Ec of the multiple quantum well laser of the second preferred embodiment of the present invention will be compared with that of the conventional semiconductor laser having a multiple quantum well structure. Again $\delta$Ev and $\delta$Ec can be calculated using model solid theory.

Preferably, the barrier layer of the second preferred embodiment is InGaAlAs (compressive strain: 0%, bandgap wavelength ($\lambda$) : 1.4$\mu$m) and the well layer is InGaAsP (compressive strain: 0.9%, bandgap wavelength ($\lambda$) : 1.9$\mu$m).

The result of calculating $\delta$Ev and $\delta$Ec is as follows:

$$\delta Ev = 67.3 \text{ (meV)}, \quad \delta Ec = 136.2 \text{ (meV)}$$

As shown above, the semiconductor laser of the second preferred embodiment can decrease $\delta$Ev even more than that of the first preferred embodiment, and can increase $\delta$Ec even more than that of the first preferred embodiment.

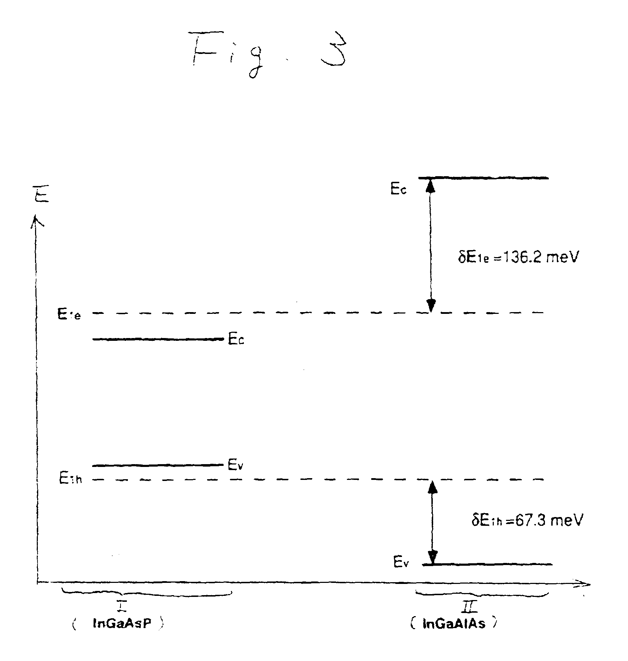

Turning now to figure 3, regions I and II show band-diagrams of InGaAsP as the well layer and InGaAlAs as the barrier layer according to the second preferred embodiment of the present invention.

Since the second preferred embodiment can decrease $\delta$Ev, the probability of recombination between electrons and holes increases, and as a result, the internal quantum efficiency of the semiconductor laser increases. Also, the second preferred embodiment increases $\delta$Ec. Therefore, electron over-flow from the quantum well can decrease. Accordingly, the second preferred embodiment can achieve a semiconductor laser of high power.

While the present invention has been described with reference to the illustrative embodiments, this description is not intended to be construed in a limiting sense. Various modifications of the illustrative embodiments, as well as other embodiments of the invention will be apparent to those skilled in the art on reference to this description. It is therefore contemplated that the appended claims will cover any such modifications or embodiments as fall within the true scope of the invention.

## Claims

1. A semiconductor laser comprising a multiple quantum well structure having a well layer and a barrier layer, wherein the barrier layer comprises InGaAlAs.

2. A semiconductor laser according to claim 1, wherein the multiple quantum well structure comprises a plurality of alternating well and barrier layers.

3. A semiconductor laser according to claim 2, wherein the barrier layers comprise InGaAlAs layers.

4. A semiconductor laser according to any preceding claim, wherein the InGaAlAs has a compressive strain of 0% and a bandgap wavelength of 1.4μm.

5. A semiconductor laser according to any preceding claim, wherein the or each well layer comprises InGaAs.

6. A semiconductor laser according to claim 5, wherein the InGaAs has a compressive strain of 0.6% and a bandgap wavelength of 1.92μm.

7. A semiconductor laser according to any one of claims 1 to 4, wherein the or each well layer comprises InGaAsP.

8. A semiconductor laser according to claim 7, wherein the InGaAsP has a compressive strain of 0.9% and a bandgap wavelength of 1.90μm.

9. A semiconductor laser according to any preceding claim, wherein the multiple quantum well structure is sandwiched between separated confinement heterostructure layers, and a clad layer formed on one of the separated confinement heterostructure layers.

10. A semiconductor laser according to claim 9, wherein the separated confinement heterostructure layers include an InGaAlAs layer which has a compressive strain of 0% and a bandgap wavelength of 1.2μm.

Fig. 1

Fig. 2

Fig. 3

δE$_{1e}$ =136.2 meV

δE$_{1h}$ =67.3 meV

I
( InGaAsP )

II
( InGaAlAs )

Fig. 4
PRIOR ART

**European Patent Office**

**EUROPEAN SEARCH REPORT**

Application Number

EP 98 30 1396

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US 5 381 434 A (BHAT RAJARAM ET AL) 10 January 1995 | 1-4,7-9 | H01S3/19 |
| Y | * column 2, line 45 - column 5, line 34 * <br> * column 7, line 8 - line 13; figures 4,5 * | 5,6,10 | |
| X | KASUKAWA A ET AL: "VERY LOW THRESHOLD CURRENT DENSITY 1.5 UM GALNAS/ALGALNAS GRADED-INDEX SEPARATE-CONFINEMENT-HETEROSTRUCTURE STRAINED QUANTUM WELL LASER DIODES GROWN BY ORGANOMETALLIC CHEMICAL VAPOR DEPOSITION" <br> APPLIED PHYSICS LETTERS, <br> vol. 59, no. 20, 11 November 1991, <br> pages 2486-2488, XP000350199 | 1-3 | |
| Y | * the whole document * | 5,6,10 | |
| X | PATENT ABSTRACTS OF JAPAN <br> vol. 097, no. 006, 30 June 1997 <br> & JP 09 036479 A (MATSUSHITA ELECTRIC IND CO LTD), 7 February 1997, | 1-3,5,9 | TECHNICAL FIELDS SEARCHED (Int.Cl.6) |
| A | * abstract * | 4,6,7,10 | H01S |

The present search report has been drawn up for all claims

| Place of search | Date of completion of the search | Examiner |
|---|---|---|
| THE HAGUE | 12 June 1998 | Claessen, L |

EPO FORM 1503 03.82 (P04C01)